(19) Europäisches Patentamt / European Patent Office / Office européen des brevets

(11) **EP 3 790 040 B1**

(12) **EUROPEAN PATENT SPECIFICATION**

(45) Date of publication and mention
of the grant of the patent:
**21.08.2024 Bulletin 2024/34**

(21) Application number: **19793867.3**

(22) Date of filing: **15.03.2019**

(51) International Patent Classification (IPC):
*H01L 21/66* *(2006.01)* *C30B 29/06* *(2006.01)*
*C30B 33/02* *(2006.01)* *C30B 33/04* *(2006.01)*

(52) Cooperative Patent Classification (CPC):
**H01L 22/12; C30B 29/06; C30B 33/02;
C30B 33/04; H01L 22/20**

(86) International application number:
**PCT/JP2019/010726**

(87) International publication number:
**WO 2019/208013 (31.10.2019 Gazette 2019/44)**

(54) **METHOD OF SORTING SILICON SINGLE CRYSTAL SUBSTRATE**

AUSWAHLVERFAHREN EINES SILIZIUM-EINKRISTALLSUBSTRATS

PROCÉDÉ DE SÉLECTION DE SUBSTRAT DE SILICIUM MONOCRISTALLIN

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.04.2018 JP 2018083848**

(43) Date of publication of application:
**10.03.2021 Bulletin 2021/10**

(73) Proprietor: **Shin-Etsu Handotai Co., Ltd.
Tokyo 100-0004 (JP)**

(72) Inventor: **TAKENO, Hiroshi
Annaka-shi, Gunma 379-0196 (JP)**

(74) Representative: **Wibbelmann, Jobst
Wuesthoff & Wuesthoff
Patentanwälte und Rechtsanwalt PartG mbB
Schweigerstrasse 2
81541 München (DE)**

(56) References cited:
JP-A- 2012 199 299    JP-A- 2016 127 192
JP-A- 2016 127 192    JP-A- H 077 060
US-A1- 2016 282 284

• LAUER K ET AL: "Detailed analysis of the microwave-detected photoconductance decay in crystalline silicon", JOURNAL OF APPLIED PHYSICS, AMERICAN INSTITUTE OF PHYSICS, US, vol. 104, no. 10, 19 November 2008 (2008-11-19), pages 104503 - 104503, XP012116556, ISSN: 0021-8979, DOI: 10.1063/1.3021459

**Description**

TECHNICAL FIELD

The present invention relates to: a method for selecting a silicon single crystal substrate.

BACKGROUND ART

In recent years, improvement of energy efficiency and reduction of greenhouse gases have been strongly required, and demand for an inverter which is a power semiconductor device has been growing. In order to increase the efficiency and reduce the size of an inverter device, a rise in the frequency of semiconductor devices is desired, and for this purpose, it is necessary to suppress power loss in semiconductor devices.

Main semiconductor devices that configure an inverter include IGBT (Insulated Gate Bipolar Transistor) and FWD (Free Wheeling Diode).

In an IGBT, when turning off from an on-state to an off-state in a switching operation, a tail current, which flows until carriers accumulated in a drift layer recombine and disappear, is generated. Therefore, with rise in frequency, there is a problem that power loss when turning off (turn-off loss) is increased.

In the case of an FWD, when a flowing current is cut off, a large amount of carriers present inside flow in the opposite direction, and after the reverse current increases to a maximum value, the reverse current starts to decrease, and this causes a period of time during which a tail current flows. When the tail current is large, there is a problem that power loss on reverse recovery (reverse recovery loss) increases.

As described, lowering the tail current on turning off of the IGBT and the tail current on reverse recovery of the FWD to lower the overall power loss is important for raising the frequency and improving the efficiency of an inverter.

There are methods of forming an area with a short carrier recombination lifetime by irradiating with a particle beam or the like in order to lower the turn-off loss of the IGBT and reverse recovery loss of the FWD (Patent Document 1, Patent Document 2, and Patent Document 3). In these methods, by shortening the carrier recombination lifetime of a certain area, the tail current on turning off of the IGBT and the tail current on reverse recovery of the FWD can be lowered effectively, and as a result, the overall power loss can be lowered.

Moreover, since formation of oxygen donors in a silicon single crystal substrate which causes a slight variation in resistivity of the silicon single crystal substrate becomes a problem in breakdown voltage characteristics of power devices, an FZ (Floating Zone) silicon single crystal substrate which hardly contains oxygen or a silicon single crystal substrate having oxygen concentration extremely lowered by an MCZ method provided by adding application of a magnetic field to a CZ (Czochralski) method are often used in high-performance devices.

As a method for measuring carrier recombination lifetime, a microwave photoconductive decay method (Microwave Photo Conductive Decay method: $\mu$-PCD method) is widely used. In this $\mu$-PCD method, firstly, a silicon single crystal substrate is irradiated with a light pulse having a greater energy than the bandgap of a silicon single crystal so that excess carriers are generated in the silicon single crystal substrate (that is, excess carriers are injected). Conductivity of a wafer increases due to the generated excess carriers, but subsequently, conductivity decreases with the passage of time because of excess carriers disappearing due to recombination. By detecting this change as change in reflective microwave power with time (excess carrier decay curve) and analyzing, recombination lifetime can be obtained. Note that when a silicon single crystal substrate is irradiated with a particle beam, a defect that forms a level which becomes a recombination center is generated in a forbidden band, and recombination lifetime is shortened.

Recombination lifetime is defined as the time until excess carrier concentration decays to $1/e$ (=approximately 0.368) due to recombination (Non Patent Document 1). A time constant of the decay obtained from a decaying portion that can be regarded as an exponential function of the reflective microwave power (primary mode) is referred to as primary mode lifetime, and the time until the reflective microwave power decays to $1/e$ of the reflective microwave power at the time of light pulse irradiation is referred to as $1/e$ lifetime. In the case of either definition for recombination lifetime, the recombination lifetime is obtained by analyzing a portion in the excess carrier decay curve having several ten percent, which is comparatively high, of an excess carrier concentration at the time of injection.

Patent document JP 2016 127192 A discloses a method for selecting a silicon single crystal substrate comprising substrate preparation, particle beam irradiation, a recovery heat treatment, a measurement using the microwave photoconductive decay method, and finally selecting a substrate, but is silent on the selection criterion according to the present invention.

Patent document US 2016/282284 A1 discloses carrier recombination lifetime and dividing a decay curve into a rapid decay part and a slow decay part, but does not give further details.

Patent document JP H07 7060 A discloses a curve with a lie and a lie 2 criterion, but does not give any hint to calculating $\Delta t$Tail (X).

CITATION LIST

PATENT LITERATURE

Patent Document 1: Japanese Unexamined Patent Application Publication No. H10-074959
Patent Document 2: Japanese Unexamined Patent Application Publication No. 2014-056881
Patent Document 3: Japanese Unexamined Patent Application Publication No. H06-021358

NON PATENT LITERATURE

Non Patent Document 1: JEIDA-53-1997 "Test Method for Recombination Lifetime in Silicon wafers by Measurement of Photoconductivity Decay by Microwave Reflectance"

SUMMARY OF INVENTION

TECHNICAL PROBLEM

As described above, in the manufacturing process of a power device, technology of suppressing tail current by using particle beam irradiation to control carrier recombination lifetime is used. However, there has been a problem that the characteristics of recombination lifetime which is concerned with the decay of excess carriers with a comparatively high concentration does not necessarily reflect the characteristics of a tail current in which the decay of excess carriers with a comparatively low concentration is concerned.

In addition, generally, it is acknowledged that if recombination lifetime is short (that is, if the decay of excess carriers in high concentration is fast), tail current is suppressed (that is, the decay of excess carriers in low concentration also becomes fast). However, this is not necessarily the case, and there has been a problem that the decay of excess carriers in low concentration is sometimes slow even when recombination lifetime is short.

In addition, to further promote high speed and low power loss of switching devices, a silicon single crystal substrate which allows a tail current to be suppressed with more certainty is desired. That is, a silicon single crystal substrate that can suppress a tail current more certainly by controlling recombination lifetime is desired, but there has been no method for selecting such a silicon single crystal substrate.

The present invention has been made in view of the above problem, and an object thereof is to provide a method for selecting a silicon single crystal substrate that can suppress a tail current by controlling recombination lifetime. Furthermore, an object of the present invention is to provide a silicon single crystal substrate that can suppress a tail current by controlling recombination lifetime.

SOLUTION TO PROBLEM

To achieve the object, the present invention provides a method for selecting a silicon single crystal substrate for controlling carrier recombination lifetime as set out in the appended claims 1 and 2.

By selecting a silicon single crystal substrate using such a method for selecting, it is possible to select a silicon single crystal substrate with a tail current suppressed with more certainty by controlling recombination lifetime. Furthermore, by fabricating devices using a silicon single crystal substrate selected in this manner, a tail current can be suppressed by controlling recombination lifetime in a power device for controlling carrier recombination lifetime by a particle beam irradiation and a subsequent recovery heat treatment to suppress a tail current. In this manner, power loss can be reduced.

In this event, in the measurement step, a microwave photoconductive decay method ($\mu$-PCD method) is used as a method for measuring the decay curve.

In this manner, by using a $\mu$-PCD method, the excess carrier decay curve can be measured extremely simply in a short time.

Furthermore, in the judgement step, the silicon single crystal substrate is preferably judged as acceptable in a case where the value of the $\Delta t_{Tail}(X)$ is 2 usec or less when an excess carrier concentration has decayed to X% ($1 \leq X \leq 10$) of the excess carrier concentration at the time of injection.

By judging under such judgement conditions, it is possible to select a silicon single crystal substrate that can suppress a tail current more certainly by controlling recombination lifetime.

Furthermore, the present description describes a silicon single crystal substrate for controlling carrier recombination lifetime.

Such a silicon single crystal substrate is a silicon single crystal substrate in which the decay of excess carriers in low concentration becomes fast in a power device, etc. for suppressing a tail current by controlling carrier recombination lifetime, and therefore, weak tail current can be suppressed, and in this manner, power loss can be reduced.

ADVANTAGEOUS EFFECTS OF INVENTION

According to the inventive method for selecting a silicon single crystal substrate, it is possible to select a silicon single crystal substrate that can suppress a tail current with certainty by controlling recombination lifetime when carrier recombination lifetime is controlled by a particle beam irradiation and a subsequent recovery heat treatment. Consequently, power loss can be reduced with certainty in a power device, etc. for suppressing a tail current by controlling carrier recombination lifetime. Furthermore, the inventive silicon single crystal substrate makes it possible to suppress a tail current certainly by controlling recombination lifetime in a power device for suppressing a tail current by controlling carrier recombination lifetime. Thus, power loss can be reduced with certainty.

BRIEF DESCRIPTION OF DRAWINGS

FIG. 1 is a diagram showing the flow of the inventive method for selecting a silicon single crystal substrate.
FIG. 2 is a graph showing an example of an excess carrier decay curve measured in an experimental example.
FIG. 3 is a graph showing definitions of LT, $t_{Tail}$ (X), and $\Delta t_{Tail}$ (X) in an excess carrier decay curve.
FIG. 4 is a graph showing the change in LT measured in the experimental example caused by a recovery heat treatment.
FIG. 5 is a graph showing the change in $t_{Tail}$ (X) measured in the experimental example caused by a recovery heat treatment.
FIG. 6 shows graphs showing the change in $\Delta t_{Tail}$(X) in the excess carrier decay curve of each sample measured in the experimental example caused by a recovery heat treatment. (a) is a case where X=10, (b) is a case where X=5, (c) is a case where X=3, and (d) is a case where X=1.
FIG. 7 shows graphs showing the relation between a light element concentration and $\Delta t_{Tail}$(X) in the excess carrier decay curve of each sample measured in the experimental example. (a) is a graph showing the relation with oxygen concentration, (b) with nitrogen concentration, (c) with carbon concentration, and (d) with phosphorous concentration.

DESCRIPTION OF EMBODIMENTS

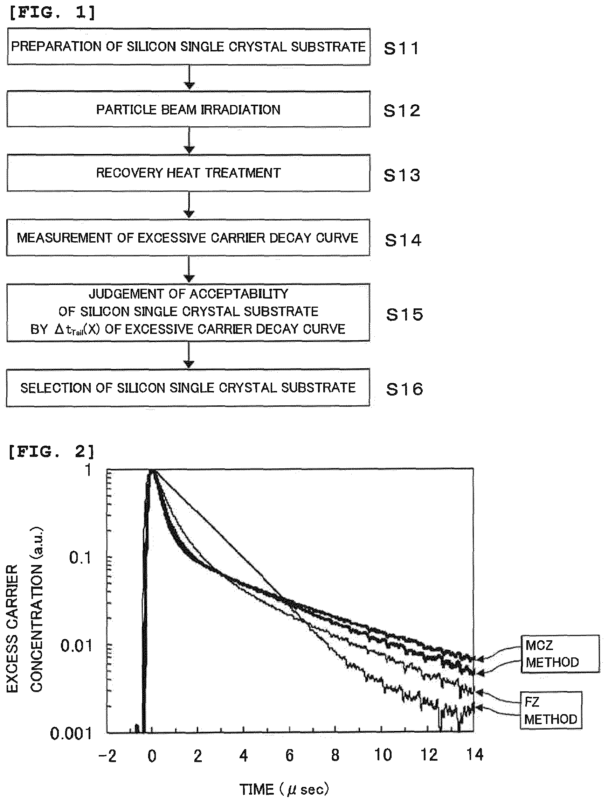

Hereinafter, the present invention will be described in detail with reference to the drawings as an example of an embodiment.
As described above, in the manufacturing process of a power device, technology of suppressing tail current by using particle beam irradiation to control carrier recombination lifetime is used. However, there has been a problem that the characteristics of recombination lifetime which is concerned with the decay of excess carriers with a comparatively high concentration does not necessarily reflect the characteristics of a tail current which is concerned with the decay of excess carriers with a comparatively low concentration. In addition, to further promote high speed and low power loss of switching devices, a silicon single crystal substrate in which a weaker tail current can be suppressed is desired. That is, a silicon single crystal substrate that can suppress a tail current with certainty by controlling recombination lifetime is desired, but there has been no method for selecting such a silicon single crystal substrate.
Accordingly, the present inventor has keenly studied and found out that when a silicon single crystal substrate is subjected to a particle beam irradiation and a recovery heat treatment, and then excess carriers are injected, and the decay of a carrier concentration in relation to time elapsed subsequently is measured, the decay of excess carriers in low concentration (hereinafter, sometimes referred to as "tail decay characteristics") is sometimes different from the decay predicted from the recombination lifetime obtained from the decay of excess carriers in high concentration (hereinafter, sometimes referred to as "ideal tail decay characteristics"), and that the degree by which the decay differs varies according to the silicon single crystal ingot from which the silicon single crystal substrate is fabricated. Moreover, the present inventor has found a silicon single crystal ingot having almost ideal tail decay characteristics. Furthermore, the present inventor has found out that it is difficult to select a silicon single crystal substrate having such almost ideal tail decay characteristics with high precision with general silicon single crystal ingot specifications, and completed the present invention.
Hereinafter, the inventive method for selecting a silicon single crystal substrate will be described with reference to FIG. 1. The present invention is a method for selecting a silicon single crystal substrate for controlling carrier recombination lifetime.

Firstly, a preparation step of preparing a silicon single crystal substrate as a candidate for a silicon single crystal substrate for controlling carrier recombination lifetime by fabrication from a silicon single crystal ingot is performed (S11 in FIG. 1). The specifications (diameter, resistivity, and the like) of the silicon single crystal substrate prepared here are not particularly limited, but are preferably made to meet requirements of the device.

In addition, the method for preparing this silicon single crystal substrate is not particularly limited in the present invention. For example, the silicon single crystal substrate can be prepared by slicing off a silicon wafer from a silicon single crystal ingot, performing a chemical etching treatment on the silicon wafer to eliminate slicing damage, and then performing chemical-mechanical polishing.

Next, a particle beam irradiation step (S12 in FIG. 1) and a recovery heat treatment step (S13 in FIG. 1) are performed. The conditions of the particle beam irradiation step and the recovery heat treatment step may be any conditions, and conventionally performed conditions can be applied to the present invention.

After preparing a silicon single crystal substrate as described above, firstly, a particle beam irradiation step of irradiating the prepared silicon single crystal substrate with a particle beam is performed (S12 in FIG. 1). The conditions of the particle beam irradiation step are not particularly limited, but can be conditions used in a recombination lifetime controlling process of power devices. For example, the irradiation can be performed with an electron beam as the particle beam at an acceleration voltage of 0.5 to 2 MV and an irradiation dosage of $1 \times 10^{14}/cm^2$ or more and $1 \times 10^{16}/cm^2$ or less. In addition, the irradiation can be performed with protons as the particle beam at an acceleration voltage of 2 to 8 MV and a dosage of $1 \times 10^{11}/cm^2$ or more and $1 \times 10^{13}/cm^2$ or less. In addition, charged particles other than an electron beam or protons, for example helium ions or the like may be selected and used.

Next, a recovery heat treatment step of heat-treating the silicon single crystal substrate after the particle beam irradiation step is performed (S13 in FIG. 1). The conditions of the recovery heat treatment step are not particularly limited, but can be conditions used in a recombination lifetime controlling process of power devices. For example, a temperature can be set to 300°C or higher and 400°C or lower, a time can be set to 10 minutes or more and 120 minutes or less, and an atmosphere can be nitrogen, oxygen, hydrogen, or the like.

Next, a measurement step of injecting excess carriers into the silicon single crystal substrate after the recovery heat treatment step and measuring an excess carrier decay curve, which is a decay curve of an excess carrier concentration in relation to time elapsed after injecting the excess carriers, is performed (S14 in FIG. 1). In this measurement step, a microwave photoconductive decay method ($\mu$-PCD method) is used as the method for measuring the decay curve. The measurement conditions in the $\mu$-PCD method can be conditions generally used, for example, the measurement can be performed under conditions described in Non Patent Document 1 "JEIDA-53-1997 'Test Method for Recombination Lifetime in Silicon wafers by Measurement of Photoconductivity Decay by Microwave Reflectance'". In addition, as the measuring apparatus, a commercially available apparatus can be used. In this manner, by using a $\mu$-PCD method, the excess carrier decay curve can be measured extremely simply in a short time.

Besides recombination centers generated in the silicon single crystal substrate, the excess carrier decay curve is also affected by surface recombination on the surface of the silicon single crystal substrate. When surface recombination of the silicon single crystal substrate becomes a problem in the measurement of the excess carrier decay curve, a treatment for suppressing surface recombination is performed. As this treatment for suppressing surface recombination, a thermal oxidation treatment (oxide film passivation) or an electrolytic solution treatment (chemical passivation) are generally used.

When oxide film passivation is used, an oxide film is preferably formed on the surface of the silicon single crystal substrate before the particle beam irradiation step. When oxide film passivation is performed before the particle beam irradiation step, surface recombination is suppressed, and there is no risk of recombination centers generated by particle beam irradiation disappearing. The oxide film can be formed by a heat treatment in an oxidizing atmosphere, for example. As conditions for the oxide film forming heat treatment, for example, a temperature can be set to 900°C or higher and 1100°C or lower, and a time can be set to 10 minutes or more and 60 minutes or less. When chemical passivation is used, in order to avoid the effect of change in passivation effect with the passage of time, the chemical passivation is preferably performed immediately before measuring the excess carrier decay curve.

Next, a judgement step of judging whether or not the silicon single crystal substrate is acceptable based on the excess carrier decay curve measured in the above is performed (S15 in FIG. 1). Specifically, the judgement step is performed as follows. Firstly, in the measured excess carrier decay curve, a time LT until the excess carrier concentration decays to 1/e and a time $t_{Tail}(X)$ until the excess carrier concentration decays to X% ($1 \leq X \leq 10$) are obtained. Subsequently, $\Delta t_{Tail}(X)$, which is a difference between the $t_{Tail}(X)$ and an ideal (theoretical) decay time $[-LT \times \ln(X/100)]$ until the excess carrier concentration decays to X% is calculated using the following equation 1.

$$\Delta t_{Tail}(X) = t_{Tail}(X) - [-LT \times \ln(X/100)] \cdots (1)$$

The silicon single crystal substrate is judged as acceptable when a value of the $\Delta t_{Tail}(X)$ calculated in this manner is a predetermined judgement value or less.

Difference in $\Delta t_{Tail}(X)$ due to the silicon single crystal ingot can be evaluated with high sensitivity by setting the ratio X% of the excess carrier concentration in the judgement step to 10% or less. Thus, a silicon single crystal substrate for certainly suppressing a tail current by controlling recombination lifetime can be selected with more certainty. Furthermore, it is possible to prevent the excess carrier concentration becoming too low, making it impossible to measure with precision, by setting the ratio X% of the excess carrier concentration in the above-described judgement step to 1% or more.

In addition, the $\Delta t_{Tail}(X)$ is most preferably zero regardless of the conditions of the particle beam irradiation step and the recovery heat treatment step, but this is difficult with current manufacturing technology. Accordingly, it is desirable to determine the judgement value for the $\Delta t_{Tail}(X)$ so that, in a silicon single crystal ingot that can be manufactured by a current manufacturing technology, the $\Delta t_{Tail}(X)$ becomes as short as possible within a range considering the balance between manufacturing cost and the effect of improving device characteristics.

For example, in the judgement step, the silicon single crystal substrate can be judged as acceptable in a case where the value of the $\Delta t_{Tail}(X)$ is 2 psec or less when a remaining excess carrier concentration has decayed to X% ($1 \leq X \leq 10$) of the excess carrier concentration at the time of injection. By judging under such judgement conditions, it is possible to select a silicon single crystal substrate that can suppress a tail current more certainly by controlling recombination lifetime.

A silicon single crystal substrate that satisfies such a judgement value or less is a silicon single crystal substrate that makes it possible to suppress a tail current with certainty by controlling recombination lifetime in a power device for controlling carrier recombination lifetime by a particle beam irradiation and a subsequent recovery heat treatment.

The following can be considered as a reason why tail decay characteristics deviate from ideal tail decay characteristics in an excess carrier decay curve due to the silicon single crystal ingot.

In the tail portion having a lowered excess carrier concentration of an excess carrier decay curve, decay of excess minority carriers (holes in the case of an N-conductive type silicon substrate) is dominant. When there is no external force working, the decay of excess carriers progresses by recombination of excess electrons and holes, and therefore, the decay of excess carriers is promoted by a rise in the concentration of defects that become carrier recombination centers. On the other hand, when defects that do not become carrier recombination centers but become carrier traps are present, recombination of carriers is suppressed by repeating capture and release of carriers, and the decay of excess carriers is sometimes suppressed. Accordingly, it can be conjectured that some factor of the silicon single crystal ingot raises the concentration of defects that become minority carrier traps, suppressing the decay of excess minority carriers, thus making the tail decay characteristics deviate from the ideal tail decay characteristics due to the silicon single crystal ingot.

Defects that affect the decay of excess carriers in high concentration are mainly carrier recombination centers, but defects that affect the decay of excess carriers in low concentration are both carrier recombination centers and minority carrier traps. Therefore, when minority carrier traps are not present, recombination lifetime reflects the decay time of excess carriers in low concentration, but when minority carrier traps are present, recombination lifetime does not reflect the decay time of excess carriers in low concentration.

The reality of minority carrier traps is not clear, but they are considered to be composites of point defects (atomic vacancies and interstitial silicons) generated by particle beam irradiation and light element impurities (dopant, carbon, oxygen, nitrogen, or the like) contained in a silicon single crystal. Therefore, a silicon single crystal substrate sliced off from the same silicon single crystal ingot having an almost uniform light element impurity concentration has almost the same tail decay characteristics. However, since the concentration of minority carrier traps varies according to absolute concentration and concentration balance of the light element impurity, selection by the concentration of only one light element impurity is difficult.

After the above-described judgement step, subsequently, a selection step of selecting a silicon single crystal substrate fabricated from the same silicon single crystal ingot as the silicon single crystal ingot from which the silicon single crystal substrate judged as acceptable in the judgement was fabricated as the silicon single crystal substrate for controlling carrier recombination lifetime is performed (S16 in FIG. 1). When a silicon single crystal substrate is selected in this manner, a silicon single crystal substrate that makes it possible to suppress a tail current with certainty by controlling recombination lifetime can be selected with certainty in a power device for controlling carrier recombination lifetime by a particle beam irradiation and a subsequent recovery heat treatment.

Fabrication of the silicon single crystal substrate from the same silicon single crystal ingot as the silicon single crystal ingot from which the silicon single crystal substrate judged as acceptable in the judgement step was fabricated may be performed after completing the steps shown in S11 to S15 in FIG. 1, but multiple silicon single crystal substrates can be fabricated at the same time when fabricating a candidate silicon single crystal substrate from the silicon single crystal ingot in S11.

A silicon single crystal substrate selected in this manner by the method for selecting a silicon single crystal substrate according to the present invention is a silicon single crystal substrate that makes it possible to suppress a tail current with certainty by controlling recombination lifetime in a power device for controlling carrier recombination lifetime by a particle beam irradiation and a subsequent recovery heat treatment, and power loss can be reduced with certainty. Accordingly, it is possible to select a silicon single crystal substrate suitable as a silicon single crystal substrate for a power device for controlling carrier recombination lifetime by a particle beam irradiation and a subsequent recovery heat treatment.

Subsequently, the inventive silicon single crystal substrate will be described.

The present inventor has succeeded in finding a silicon single crystal substrate having almost ideal tail decay characteristics in a silicon single crystal substrate subjected to a particle beam irradiation and a recovery heat treatment. Furthermore, the present inventor has found out that it is difficult to select a silicon single crystal substrate having almost ideal tail decay characteristics with high precision with general silicon single crystal ingot specifications, and completed the inventive silicon single crystal substrate.

The inventive silicon single crystal substrate is a silicon single crystal substrate for controlling carrier recombination lifetime, where after performing a particle beam irradiation and a recovery heat treatment on the silicon single crystal substrate, excess carriers are injected, and when a decay curve of an excess carrier concentration in relation to time elapsed after injecting the excess carriers (excess carrier decay curve) is measured, in the excess carrier decay curve, the $\Delta t_{Tail}(X)$ when the remaining excess carrier concentration has decayed to X% ($1 \leq X \leq 10$) of the excess carrier concentration at the time of injection is 2 usec or less. Calculation of the $\Delta t_{Tail}(X)$ is performed in the same manner as the above-described method for selecting a silicon single crystal substrate. That is, firstly, in the excess carrier decay curve, a time LT until the excess carrier concentration decays to 1/e and a time $t_{Tail}(X)$ until the excess carrier concentration decays to X% ($1 \leq X \leq 10$) are obtained. Subsequently, $\Delta t_{Tail}(X)$, which is a difference between the $t_{Tail}(X)$ and an ideal decay time $[-LT \times \ln(X/100)]$ until the excess carrier concentration decays to X% is calculated using the following equation 1.

$$\Delta t_{Tail}(X) = t_{Tail}(X) - [-LT \times \ln(X/100)] \cdots (1)$$

The inventive silicon single crystal substrate is a silicon single crystal substrate such that the value of the $\Delta t_{Tail}(X)$ in the equation 1 is 2 psec or less.

Such a silicon single crystal substrate makes it possible to suppress a tail current certainly by controlling recombination lifetime in a power device for suppressing a tail current by controlling carrier recombination lifetime. Thus, power loss can be reduced with certainty.

The inventive silicon single crystal substrate is suitable as a silicon single crystal substrate for a power device for controlling carrier recombination lifetime by a particle beam irradiation and a subsequent recovery heat treatment. In controlling recombination lifetime, an electron beam, protons, helium ions, or the like is sometimes used as the particle beam, but the inventive silicon single crystal substrate makes it possible to suppress a tail current with certainty by controlling recombination lifetime as described above when recombination lifetime is controlled using any particle beam irradiation.

In the present invention, a reason to use the above-described method for selecting a silicon single crystal substrate to suppress a tail current with certainty in a silicon single crystal substrate for controlling carrier recombination lifetime by a particle beam irradiation and a subsequent recovery heat treatment is based on the knowledge obtained by an experiment described below.

(Experimental Example)

Multiple silicon single crystal substrates sliced off from each of multiple silicon single crystal ingots manufactured by an FZ method and an MCZ method were prepared. A dopant type, dopant concentration, oxygen concentration, carbon concentration, nitrogen concentration, a diameter, and a crystal plane orientation of each of the multiple silicon single crystal substrates are as described below.

The dopant type/concentration: phosphorous/$6.1 \times 10^{13}$ to $5.6 \times 10^{14}$ atoms/cm$^3$,

the oxygen concentration: less than 0.1 ppma to 11.0 ppma,
the carbon concentration: 0.01 to 0.07 ppma,
the nitrogen concentration: 0 to $5.0 \times 10^{15}$ atoms/cm$^3$,
the diameter: 200 mm, 150 mm, and
the crystal plane orientation: (100).

The oxygen concentration was measured by an infrared absorption method (conversion factor: JEIDA), and the carbon concentration and the nitrogen concentration were measured by secondary ion mass spectrometry (SIMS).

Next, oxide film passivation was performed on the prepared multiple silicon single crystal substrates. In this event, the oxide film passivation was performed by forming an oxide film by an oxidation heat treatment. The heat treatment temperature was 1000°C, the time was 60 minutes, and the atmosphere was oxygen.

Next, the multiple silicon single crystal substrates after the oxide film formation were irradiated with an electron beam. In this event, an irradiation dosage of the electron beam was $1\times10^{15}/cm^2$, and an acceleration voltage of the electron beam was 2 MV.

Next, the multiple silicon single crystal substrates irradiated with the electron beam were subjected to a recovery heat treatment. The heat treatment temperature was 360°C, the atmosphere was nitrogen, and the time was made to range from 0 to 45 minutes.

Next, in the multiple silicon single crystal substrates subjected to the recovery heat treatment, an excess carrier decay curve was measured.

A microwave photoconductive decay method (Microwave Photo Conductive Decay method: $\mu$-PCD method) was used for measuring the excess carrier decay curve. In this $\mu$-PCD method, firstly, a silicon single crystal substrate is irradiated with a light pulse having a greater energy than the bandgap of a silicon single crystal so that excess carriers are generated in the silicon single crystal substrate. Conductivity of a silicon single crystal substrate increases due to the generated excess carriers, but subsequently, conductivity decreases with the passage of time because of excess carriers disappearing due to recombination. An excess carrier decay curve is measured by detecting this change as change in reflective microwave power with time.

An example of a measured excess carrier decay curve is shown in FIG. 2. The carrier concentration on the vertical axis of FIG. 2 is standardized with the peak concentration at the time of carrier injection set to 1. The time of the recovery heat treatment after the electron beam irradiation was 30 minutes. In FIG. 2, the thickness of the lines shows the difference in silicon single crystal ingots, and the thin lines show the cases with the FZ method and the thick lines show the cases with the MCZ method.

As described above, it can be observed that an excess carrier decay curve can be roughly divided into an early portion with a high decay rate and a latter portion with a low decay rate (tail portion) in the case of any silicon single crystal substrate, and that behavior is different in a portion with a comparatively high excess carrier concentration from which recombination lifetime can be obtained and a tail portion with a comparatively low excess carrier concentration.

Next, in the measured excess carrier decay curve, the decay time required for the remaining excess carrier concentration to become 1/e of the excess carrier concentration at the time of injection was obtained as the recombination lifetime (LT), and the decay time required for the remaining excess carrier concentration to become X% of the excess carrier concentration at the time of injection was obtained as the $t_{Tail}(X)$.

Next, using the obtained values of the LT and the $t_{Tail}(X)$, $\Delta t_{Tail}(X)$ was calculated from the equation 1.

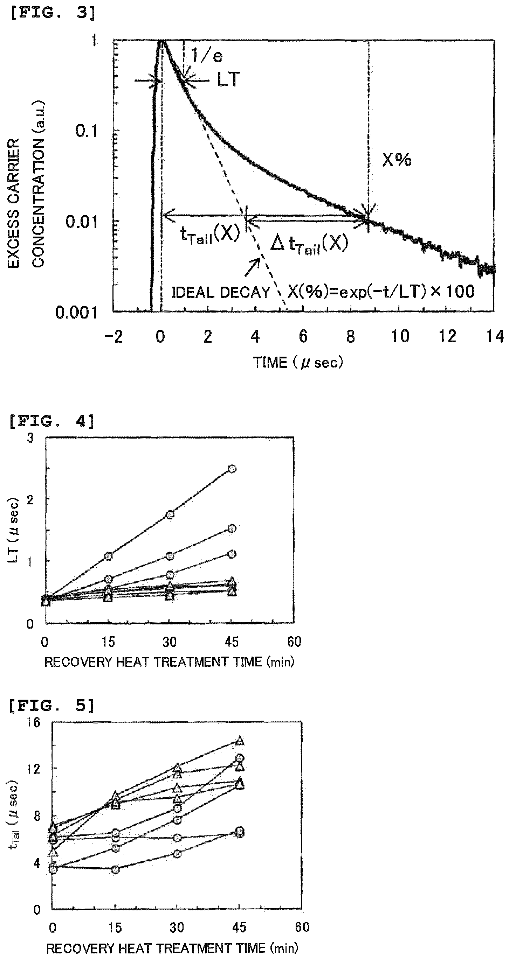

Definitions of LT, $t_{Tail}(X)$, and $\Delta t_{Tail}(X)$ in an excess carrier decay curve are illustrated in FIG. 3. The time LT is the time until the excess carrier concentration decays to 1/e (=approximately 0.368, that is, approximately 36.8%). The time $t_{Tail}(X)$ is the time until the excess carrier concentration decays to X% ($1\leq X\leq10$). As shown in FIG. 3, the excess carrier concentration X% decreases in relation to time "t" in accordance with an equation $X(\%)=\exp(-t/LT)\times100$. Here, "t" is elapsed time. When this equation is deformed, $t=[-LT\times\ln(X/100)]$. As shown by the oblique dotted line in FIG. 3, ideally, ideal tail decay characteristics $[-LT\times\ln(X/100)]$ are obtained. Deviation of the tail decay characteristics from the ideal tail decay characteristics $[-LT\times\ln(X/100)]$ can be expressed by the $\Delta t_{Tail}(X)$.

Next, examples of the change in LT and $t_{Tail}(X=1)$ caused by the recovery heat treatment are shown respectively in FIG. 4 and FIG. 5. The difference in the symbols in each graph indicates the difference in the silicon single crystal ingots, and the symbol "∘" indicates a case with the FZ method and the symbol "Δ" indicates a case with the MCZ method.

From the results of FIGS. 4 and 5, it can be observed that LT and $t_{Tail}(X)$ both have a tendency to become longer as the recovery heat treatment time becomes longer, and that the degree of the change varies depending on the silicon single crystal ingot. This is caused by the fact that the tail decay characteristics deviate from the ideal tail decay characteristics based on recombination lifetime, and that the degree of the deviation varies depending on the silicon single crystal ingot. As described, since the change in LT and $t_{Tail}(X)$ due to the recovery heat treatment varies depending on the silicon single crystal ingot, a tail decay time cannot be controlled by the difference in recombination lifetime with high precision.

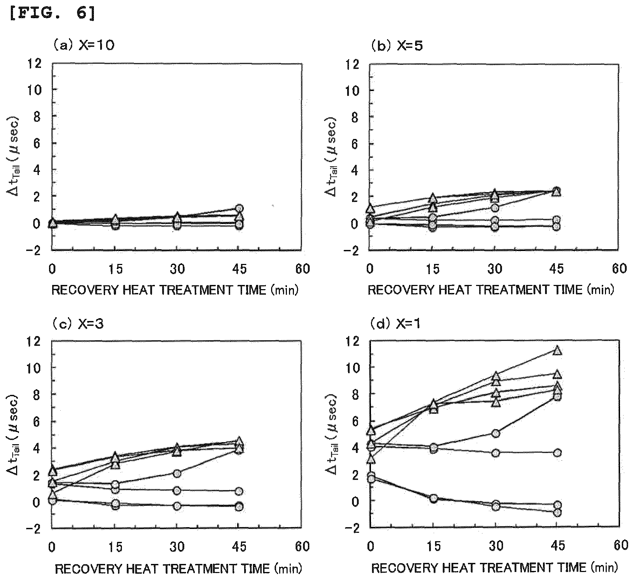

Next, change in $\Delta t_{Tail}(X)$ caused by the recovery heat treatment is shown in FIG. 6. In FIG. 6, the value of X% is 10% in (a), 5% in (b), 3% in (c), and 1% in (d). The difference in the symbols in the graphs indicates the difference in the silicon single crystal ingots, and "o" indicates a case with the FZ method and "Δ" indicates a case with the MCZ method.

From these results, it can be observed that within the range of $1\leq X\leq10$, the $\Delta t_{Tail}(X)$ caused by the silicon single crystal ingots can be evaluated with high sensitivity. In addition, it can be observed that the $\Delta t_{Tail}(X)$ caused by the silicon single crystal ingots tends to increase as the recovery heat treatment time grows longer.

As described above, it can be considered that $\Delta t_{Tail}(X)$ becomes larger as the concentration of minority carrier traps increases. Thus, it can be considered that in FIG. 6, $\Delta t_{Tail}(X)$ increases with the recovery heat treatment time because the concentration of the minority carrier traps increases with the recovery heat treatment time. There are also cases where $\Delta t_{Tail}(X)$ decreases with the recovery heat treatment time, and this can be considered to be because the concentration of the minority carrier traps decreases with the recovery heat treatment time.

Since $\Delta t_{Tail}(X)$ is ideally zero under any recombination lifetime control conditions (particle beam irradiation conditions and recovery heat treatment conditions), it can be observed from the results in FIG. 6 that a silicon single crystal substrate having almost ideal tail decay characteristics exists.

In this event, for example, under the conditions of FIG. 6, a silicon single crystal substrate having almost ideal tail decay characteristics in an excess carrier decay curve can be selected by setting the judgement value of the $\Delta t_{Tail}(X)$ to 2 usec, and therefore, a tail current can be suppressed with certainty by controlling recombination lifetime.

In this case, to what percent the X% of the $\Delta t_{Tail}(X)$ is set in the range of 1% or more and 10% or less is determined considering the time that needs to be controlled when the excess carrier concentration has decayed to what percent in device characteristics. For example, in device characteristics, when it is necessary to control the time until the excess carrier concentration decays to 1%, X% is set to 1%.

In addition, in this case, the conditions of the recovery heat treatment are determined considering the conditions of the recovery heat treatment performed to control recombination lifetime in device characteristics.

From the results of FIG. 6, for example, when X=10 and the recovery heat treatment time is 15 minutes, many silicon single crystal substrates are judged as acceptable. Meanwhile, when X=1 and the recovery heat treatment time is 45 minutes, few silicon single crystal substrates are judged as acceptable. That is, the larger the X and the shorter the recovery heat treatment time, the higher the acceptability rate of the silicon single crystal substrates, and the smaller the X and the longer the recovery heat treatment time, the lower the acceptability rate of the silicon single crystal substrate.

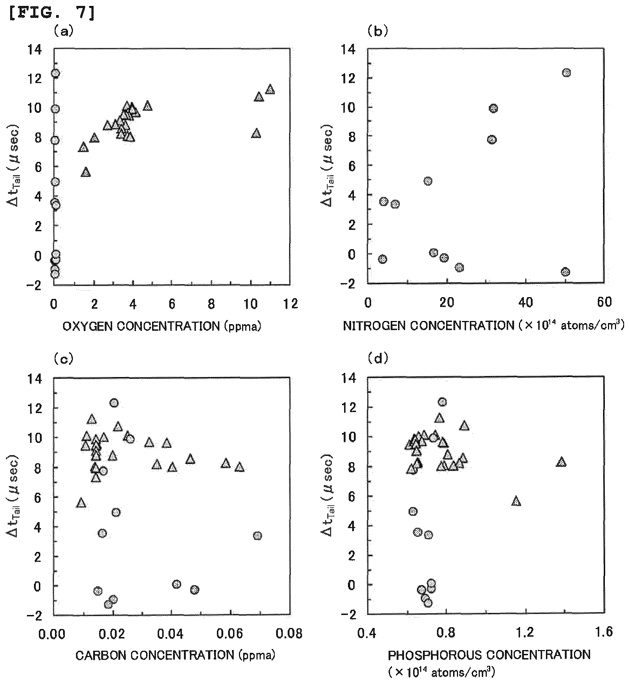

Next, the dependence of $\Delta t_{Tail}$ on light element concentrations is shown in FIG. 7. In FIG. 7, the X% is set to 1%, and (a) shows oxygen concentration dependence, (b) shows nitrogen concentration dependence, (c) shows carbon concentration dependence, and (d) shows phosphorous concentration dependence. The difference in the symbols in the graphs indicates the difference in the silicon single crystal ingots, and "∘" indicates a case with the FZ method and "Δ" indicates a case with the MCZ method.

From the results of FIG. 7, it can be observed that silicon single crystal substrates that have a small $\Delta t_{Tail}$ cannot be selected by the concentration of any of oxygen, nitrogen, carbon, or phosphorous contained in the silicon single crystal substrates.

A reason why a silicon single crystal substrate having almost ideal tail decay characteristics in an excess carrier decay curve cannot be selected only by the concentration of any of oxygen, nitrogen, carbon, or phosphorous contained in the silicon single crystal substrate as described above can be considered as follows.

When a silicon single crystal substrate is irradiated with a high-energy particle beam, a silicon atom at a lattice position is flicked out, and an interstitial silicon (hereinafter referred to as I) and a vacancy (hereinafter referred to as V) which is an empty shell thereof are produced. Since the excessively produced I or V is unstable when it is alone, they recombine (V+I→O), clustering of Is or clustering of Vs occurs, or they react with a light element impurity contained in the silicon single crystal substrate to form a composite. Additionally, the cluster of I or V or the composite of I or V and the light element impurity forms a deep level in a bandgap of silicon, functions as a recombination center of carriers, and decreases the recombination lifetime. Moreover, part of the composite works as minority carrier traps, and suppresses recombination of excess minority carriers.

It has been known that, as a defect concerning the vacancy V, V and a substitutional phosphorous Ps react to form VP (V+Ps→VP). Further, V and the interstitial oxygen Oi react to form VO (V+Oi→VO), and further, a V and VO react to form $V_2O$ (V+VO→$V_2O$) in some cases. Furthermore, a pair of V react to form VV (V+V→VV). When nitrogen is present, V and N react to form VN (V+N→VN). Since reactions of V and P, O, or N compete against each other, if VN is apt to be formed when the nitrogen concentration is high, there is a possibility that other composites to which V relates are not easily formed.

On the other hand, it has been known that, as defects to which the interstitial silicon I relates, I and substitutional boron Bs react to form interstitial boron Bi (I+Bs→Bi), and further, Bi and Oi react to form BiOi (Bi+Oi→BiOi). Furthermore, when carbon is present, I and the substitutional carbon Cs react to form an interstitial carbon Ci (I+Cs→Ci), and further, Ci and Oi or Ci and Cs react to form CiOi or CiCs (Ci+Oi→CiOi, Ci+Cs→CiCs). Moreover, I also reacts with other I to form an I cluster (I + I+...→In) . When nitrogen is present, a reaction of V and N suppresses the recombination of V and I, and hence there is a possibility that a composite to which I relates is apt to be formed.

Since the reaction of I or V and a light element impurity is dependent on each absolute concentration and a concentration balance, it is very complicated, and estimating which composite becomes dominant is difficult. When a recovery heat treatment is performed after the particle beam irradiation, the reaction becomes more complicated. Thus, it can be conjectured that the concentration of the composites that work as minority carrier traps does not depend only on the concentration of any of oxygen, nitrogen, carbon, or phosphorous contained in the silicon single crystal substrate.

Accordingly, as in the present invention, by performing a particle beam irradiation and a recovery heat treatment on the silicon single crystal substrate, and then obtaining the $\Delta t_{Tail}(X)$ in the measured excess carrier decay curve, and selecting a silicon single crystal substrate such that the value is a predetermined judgement value or less, it is possible to select a silicon single crystal substrate having almost ideal tail decay characteristics. Therefore, a tail current can be suppressed with certainty by controlling recombination lifetime.

EXAMPLE

Hereinafter, the present invention will be more specifically described with reference to Examples of the present invention and Comparative Examples.

(Example)

In the Example, regarding silicon single crystal substrates fabricated from two types of silicon single crystal ingot (ingots 1 and 2), acceptability of a silicon single crystal substrate fabricated from each silicon single crystal ingot was judged and selection was performed according to the inventive method for selecting.

(Ingot 1)

Firstly, a silicon single crystal ingot having a phosphorous concentration of $7 \times 10^{13}$ atoms/cm$^3$ (ingot 1) was grown by the FZ method. The diameter was 200 mm, and the crystal axis orientation was <100>. The oxygen concentration was less than 0.1 ppma, and the carbon concentration was 0.01 ppma. The oxygen concentration was measured by an infrared absorption method (conversion factor: JEIDA), and the carbon concentration was measured by secondary ion mass spectrometry (SIMS). Next, from the silicon single crystal ingot, a silicon single crystal substrate with a mirror-polish finish was fabricated by a standard wafer processing process.
Next, an oxide film was formed on the fabricated silicon single crystal substrate by an oxidation heat treatment (oxide film passivation). The oxidation heat treatment temperature was 1000°C, the time was 60 minutes, and the atmosphere was oxygen. Next, the silicon single crystal substrate with the oxide film formed was irradiated with an electron beam. The irradiation dosage of the electron beam was $1 \times 10^{15}$/cm$^2$, and the acceleration voltage of the electron beam was 2MV. Next, a recovery heat treatment was performed on the silicon single crystal substrate irradiated with the electron beam. The heat treatment temperature was 360°C, the atmosphere was nitrogen, and the time was 30 minutes.
Subsequently, an excess carrier decay curve of the silicon single crystal substrate subjected to the recovery heat treatment was measured by a $\mu$-PCD method, and LT and $t_{Tail}$(X=1) were obtained. As a result, LT was 1.7 $\mu$sec, and $t_{Tail}$ (X=1) was 8.0 psec. Next, $\Delta t_{Tail}$ (X=1) was calculated using the equation 1. As a result, $\Delta t_{Tail}$(X=1) was 0.2 $\mu$sec, and since this was shorter than the judgement value of 2.0 $\mu$sec, which is the standard for judging acceptability, the silicon single crystal substrate was judged as acceptable for a silicon single crystal substrate for controlling recombination lifetime. By setting the judgement value to 2.0 $\mu$sec, it was possible to select a silicon single crystal substrate having almost ideal tail decay characteristics from the silicon single crystal ingot.
Next, a silicon single crystal substrate fabricated from the same silicon single crystal ingot (ingot 1) as the silicon single crystal ingot from which the silicon single crystal substrate judged as acceptable was fabricated was selected as the silicon single crystal substrate for controlling recombination lifetime.
Next, a device was fabricated using the selected silicon single crystal substrate, and as a result of evaluating the tail current on turning off, it was confirmed that the tail current was low and suppressed.

(Ingot 2)

Firstly, a silicon single crystal ingot having a phosphorous concentration of $8 \times 10^{13}$ atoms/cm$^3$ (ingot 2) was grown by the FZ method. The diameter was 200 mm, and the crystal axis orientation was <100>. The oxygen concentration was 0.2 ppma, and the carbon concentration was 0.02 ppma. The oxygen concentration was measured by an infrared absorption method (conversion factor: JEIDA), and the carbon concentration was measured by secondary ion mass spectrometry (SIMS). Next, from the silicon single crystal ingot, a silicon single crystal substrate with a mirror-polish finish was fabricated by a standard wafer processing process.
Next, an oxide film was formed on the fabricated silicon single crystal substrate by an oxidation heat treatment (oxide film passivation). The oxidation heat treatment temperature was 1000°C, the time was 60 minutes, and the atmosphere was oxygen. Next, the silicon single crystal substrate with the oxide film formed was irradiated with an electron beam. The irradiation dosage of the electron beam was $1 \times 10^{15}$/cm$^2$, and the acceleration voltage of the electron beam was 2MV. Next, a recovery heat treatment was performed on the silicon single crystal substrate irradiated with the electron beam. The heat treatment temperature was 360°C, the atmosphere was nitrogen, and the time was 30 minutes.
Subsequently, an excess carrier decay curve of the silicon single crystal substrate subjected to the recovery heat treatment was measured by the $\mu$-PCD method, and LT and $t_{Tail}$(X=1) were obtained. As a result, LT was 0.8 $\mu$sec,

and $t_{Tail}(X=1)$ was 8.7 µsec. Next, $\Delta t_{Tail}(X=1)$ was calculated using the equation 1. As a result, $\Delta t_{Tail}(X=1)$ was 5.0 µsec. Since this was longer than the judgement value of 2.0 µsec, which is the standard for judging acceptability, the silicon single crystal substrate was judged as unacceptable for a silicon single crystal substrate for controlling recombination lifetime. It was then decided not to use a silicon single crystal substrate fabricated from the same silicon single crystal ingot (ingot 2) as the silicon single crystal ingot from which the silicon single crystal substrate judged as unacceptable was fabricated as the silicon single crystal substrate for controlling recombination lifetime.

As described above, it was confirmed that using the inventive method for selecting, tail decay time can be controlled with certainty by controlling recombination lifetime and that therefore, in a power device for controlling recombination lifetime using a particle beam irradiation and a subsequent recovery heat treatment, a silicon single crystal substrate that makes it possible to suppress a tail current certainly by controlling recombination lifetime can be selected with certainty.

It should be noted that the present invention is not limited to the above-described embodiments, and only limited to the claims. The embodiments are just examples, and any examples that have substantially the same feature and demonstrate the same functions and effects as those in the technical concept disclosed in claims of the present invention are to be considered.

## Claims

1. A method for selecting a silicon single crystal substrate for controlling carrier recombination lifetime, comprising:

a preparation step (S11) of preparing a silicon single crystal substrate as a candidate for the silicon single crystal substrate by fabrication from a silicon single crystal ingot;
a particle beam irradiation step (S12) of irradiating the prepared silicon single crystal substrate with a particle beam;
a recovery heat treatment step (S13) of heat-treating the silicon single crystal substrate after the particle beam irradiation step;
a measurement step (S14) of injecting excess carriers into the silicon single crystal substrate after the recovery heat treatment step and measuring an excess carrier decay curve, which is a decay curve of an excess carrier concentration in relation to time elapsed after injecting the excess carriers, wherein a microwave photoconductive decay method is used as a method for measuring the decay curve;
a judgement step (S15) of obtaining, in the measured excess carrier decay curve, a time LT until the excess carrier concentration decays to 1/e times the excess carrier concentration at the time of injection and a time $t_{Tail}(X)$ until the excess carrier concentration decays to X% ($1 \leq X \leq 10$) of the excess carrier concentration at the time of injection, and then calculating $\Delta t_{Tail}(X)$, which is a difference between the time $t_{Tail}(X)$ and an ideal decay time $[-LT \times \ln(X/100)]$ until the excess carrier concentration decays to X% of the excess carrier concentration at the time of injection using the following equation 1, and judging the silicon single crystal substrate as acceptable when a value of the time $\Delta t_{Tail}(X)$ is a predetermined judgement value or less; and
a selection step (S16) of selecting a silicon single crystal substrate fabricated from the same silicon single crystal ingot as the silicon single crystal ingot from which the silicon single crystal substrate judged as acceptable in the judgement was fabricated as the silicon single crystal substrate for controlling carrier recombination lifetime.

$$\Delta t_{Tail}(X) = t_{Tail}(X) - [-LT \times \ln(X/100)] \quad (1)$$

2. The method for selecting a silicon single crystal substrate according to claim 1, wherein in the judgement step, the silicon single crystal substrate is judged as acceptable in a case where the value of the $\Delta t_{Tail}(X)$ is 2 µsec or less when an excess carrier concentration has decayed to X% ($1 \leq X \leq 10$) of the excess carrier concentration at the time of injection.

## Patentansprüche

1. Verfahren zum Auswählen eines Silizium-Einkristallsubstrats zum Steuern einer Ladungsträger-Rekombinationslebensdauer, umfassend:

einen Präparationsschritt (S11), bei dem ein Silizium-Einkristallsubstrat als Kandidat für das Silizium-Einkristallsubstrat durch Herstellung aus einem Silizium-Einkristallbarren vorbereitet wird;

einen Teilchenstrahl-Bestrahlungsschritt (S12) des Bestrahlens des vorbereiteten Silizium-Einkristallsubstrats mit einem Teilchenstrahl;

einen Rückgewinnungs-Wärmebehandlungsschritt (S13) der Wärmebehandlung des Silizium-Einkristallsubstrats nach dem Teilchenstrahl-Bestrahlungsschritt;

einen Messschritt (S14) des Injizierens von Überschüssladungsträgern in das Silizium-Einkristallsubstrat nach dem Rückgewinnungs-Wärmebehandlungsschritt und des Messens einer Überschussladungsträger-Abklingkurve, die eine Abklingkurve einer Überschussladungsträger-Konzentration in Abhängigkeit von der nach dem Injizieren der Überschussladungsträger verstrichenen Zeit ist, wobei ein mikrowellenphotoleitendes Abklingverfahren als ein Verfahren zum Messen der Abklingkurve verwendet wird; und

einen Beurteilungsschritt (S15), bei dem in der gemessenen Überschussladungsträger-Abklingkurve eine Zeit LT erhalten wird, bis die Überschussladungsträger-Konzentration auf das 1/e-fache der Überschussladungsträger-Konzentration zum Zeitpunkt der Injektion abklingt, und eine Zeit $t_{Tail}$ (X), bis die Überschussladungsträger-Konzentration auf X% ($1 \leq X \leq 10$) der Überschussladungsträger-Konzentration zum Zeitpunkt der Injektion abklingt, und dann $\Delta t_{Tail}$ (X) berechnet wird, das die Differenz zwischen der Zeit $t_{Tail}$ (X) und einer idealen Abklingzeit $[-LT \times \ln(X/100)]$ ist, bis die Überschussladungsträger-Konzentration auf X% der Überschussladungsträger-Konzentration zum Zeitpunkt der Injektion abklingt, unter Verwendung der folgenden Gleichung 1, und Beurteilen des Silizium-Einkristallsubstrats als akzeptabel, wenn ein Wert der Zeit $\Delta t_{Tail}$ (X) ein vorbestimmter Beurteilungswert oder weniger ist; und

einen Auswahlschritt des Auswählens eines Silizium-Einkristallsubstrats, das aus demselben Silizium-Einkristallbarren hergestellt ist wie der Silizium-Einkristallbarren, aus dem das bei der Beurteilung als akzeptabel beurteilte Silizium-Einkristallsubstrat hergestellt wurde, als das Silizium-Einkristallsubstrat zum Steuern der Ladungsträger-Rekombinationslebensdauer.

$$\Delta t_{Tail}\ (X) = t_{Tail}\ (X) - [-LT \times \ln(X/100)] \_\_\_(1)$$

2. Verfahren zum Auswählen eines Silizium-Einkristallsubstrats nach Anspruch 1, wobei in dem Beurteilungsschritt das Silizium-Einkristallsubstrat als akzeptabel beurteilt wird, wenn der Wert von $\Delta t_{Tail}$ (X) 2 µs oder weniger beträgt, wenn eine Überschussladungsträger-Konzentration auf X% ($1 \leq X \leq 10$) der Überschussladungsträger-Konzentration zum Zeitpunkt der Injektion abgeklungen ist.

**Revendications**

1. Procédé de sélection d'un substrat monocristallin en silicium pour réguler la durée de vie de la recombinaison de supports, comprenant:

une étape de préparation (S11) consistant à préparer un substrat monocristallin en silicium comme candidat pour le substrat monocristallin en silicium par fabrication à partir d'un lingot monocristallin en silicium;

une étape de rayonnement de faisceau de particules (S12) consistant à soumettre le substrat monocristallin de silicium préparé à un faisceau de particules;

une étape de traitement thermique de récupération (S13) consistant à traiter thermiquement le substrat monocristallin en silicium après l'étape de rayonnement de faisceau de particules;

une étape de mesure (S14) consistant à injecter des supports excédentaires dans le substrat monocristallin en silicium après l'étape de traitement thermique de récupération et à mesurer une courbe de décroissance des supports excédentaires, qui est une courbe de décroissance d'une concentration de supports excédentaires en fonction du temps écoulé après l'injection des supports excédentaires, dans lequel un procédé de décroissance photoconductrice par micro-ondes est utilisé comme procédé de mesure de la courbe de décroissance;

une étape de jugement (S15) consistant à obtenir, dans la courbe de décroissance des supports en excès mesurée, un temps LT jusqu'à ce que la concentration de supports excédentaires décroisse jusqu'à 1/e fois la concentration de supports excédentaires au moment de l'injection et un temps $t_{Tail}$ (X) jusqu'à ce que la concentration de supports excédentaires décroisse jusqu'à X % ($1 \leq X \leq 10$) de la concentration des supports excédentaires au moment de l'injection, et à calculer ensuite $\Delta t_{Tail}$ (X), qui est une différence entre le temps $t_{Tail}$ (X) et un temps de décroissance idéal $[-LT \times \ln(X/100)]$ jusqu'à ce que la concentration de supports excédentaires décroisse jusqu'à X % de la concentration de supports excédentaires au moment de l'injection à l'aide de l'équation 1 suivante, et à juger le substrat monocristallin en silicium comme acceptable lorsqu'une valeur du temps $\Delta t_{Tail}$ (X) est une valeur de jugement prédéterminée ou inférieure; et

une étape de sélection (S16) consistant à sélectionner un substrat monocristallin en silicium fabriqué à partir du même lingot monocristallin en silicium que le lingot monocristallin en silicium à partir duquel le substrat monocristallin en silicium jugé acceptable dans le jugement a été fabriqué en tant que substrat monocristallin en silicium pour la régulation de la durée de vie de la recombinaison des supports.

$$\Delta t_{Tail}(X) = t_{Tail}(X) - [\ -LT \times \ln(X/100)\ ]\_\_(1)$$

2.  Procédé de sélection d'un substrat monocristallin en silicium selon la revendication 1, dans lequel dans l'étape de jugement, le substrat monocristallin en silicium est jugé comme acceptable dans le cas où la valeur de $\Delta t_{Tail}(X)$ est 2 $\mu$s ou inférieure lorsqu'une concentration de supports excédentaires a décru à X % ($1 \leq X \leq 10$) de la concentration de supports excédentaires au moment de l'injection.

[FIG. 1]

| PREPARATION OF SILICON SINGLE CRYSTAL SUBSTRATE | S11 |

↓

| PARTICLE BEAM IRRADIATION | S12 |

↓

| RECOVERY HEAT TREATMENT | S13 |

↓

| MEASUREMENT OF EXCESSIVE CARRIER DECAY CURVE | S14 |

↓

| JUDGEMENT OF ACCEPTABILITY OF SILICON SINGLE CRYSTAL SUBSTRATE BY $\Delta t_{Tail}(X)$ OF EXCESSIVE CARRIER DECAY CURVE | S15 |

↓

| SELECTION OF SILICON SINGLE CRYSTAL SUBSTRATE | S16 |

[FIG. 2]

MCZ METHOD

FZ METHOD

TIME ($\mu$sec)

EXCESS CARRIER CONCENTRATION (a.u.)

[FIG. 3]

[FIG. 4]

[FIG. 5]

[FIG. 6]

(a) X=10

(b) X=5

(c) X=3

(d) X=1

[FIG. 7]

**EP 3 790 040 B1**

**Patent documents cited in the description**

- JP 2016127192 A
- US 2016282284 A1
- JP H077060 A
- JP H10074959 A
- JP 2014056881 A
- JP H06021358 A

**Non-patent literature cited in the description**

- Test Method for Recombination Lifetime in Silicon wafers by Measurement of Photoconductivity Decay by Microwave Reflectance. *JEIDA-53-1997*